(19) Europäisches Patentamt
European Patent Office
Office européen des brevets

(11) **EP 3 650 499 B1**

(12) **EUROPEAN PATENT SPECIFICATION**

(45) Date of publication and mention
of the grant of the patent:
**08.11.2023 Bulletin 2023/45**

(51) International Patent Classification (IPC):
**C08L 33/06** (2006.01)    **C08K 3/08** (2006.01)
**C08K 5/101** (2006.01)    **C08K 5/1515** (2006.01)
**H01L 23/00** (2006.01)    **H01L 23/28** (2006.01)
**H05K 9/00** (2006.01)    **C08F 265/06** (2006.01)
**C09D 4/06** (2006.01)

(21) Application number: **18828639.7**

(22) Date of filing: **25.06.2018**

(52) Cooperative Patent Classification (CPC):
(C-Sets available)
**H01L 21/561; C08F 265/06; C08L 33/06;
C09D 4/06; H01L 23/552; H05K 9/0083;**
H01L 23/3121; H01L 2224/97        (Cont.)

(86) International application number:
**PCT/JP2018/024005**

(87) International publication number:
**WO 2019/009124 (10.01.2019 Gazette 2019/02)**

(54) **ELECTROCONDUCTIVE RESIN COMPOSITION AND METHOD FOR MANUFACTURING SHIELDED PACKAGE USING SAME**

ELEKTRISCH LEITFÄHIGE HARZZUSAMMENSETZUNG UND VERFAHREN ZUR HERSTELLUNG EINER ABGESCHIRMTEN VERPACKUNG DAMIT

COMPOSITION DE RÉSINE ÉLECTROCONDUCTRICE ET PROCÉDÉ DE FABRICATION D'UN EMBALLAGE BLINDÉ L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.07.2017 JP 2017133426**

(43) Date of publication of application:
**13.05.2020 Bulletin 2020/20**

(73) Proprietor: **Tatsuta Electric Wire & Cable Co., Ltd.**
**Higashiosaka-shi, Osaka 578-8585 (JP)**

(72) Inventors:
• **UMEDA, Hiroaki**
**Kizugawa-shi**
**Kyoto 619-0216 (JP)**
• **MATSUDA, Kazuhiro**
**Kizugawa-shi**
**Kyoto 619-0216 (JP)**
• **NAKAZONO, Hajime**
**Kizugawa-shi**
**Kyoto 619-0216 (JP)**

(74) Representative: **Zimmermann, Tankred Klaus et al**
**Schoppe, Zimmermann, Stöckeler**
**Zinkler, Schenk & Partner mbB**
**Patentanwälte**
**Radlkoferstrasse 2**
**81373 München (DE)**

(56) References cited:
WO-A1-2016/084342        WO-A1-2017/023747
JP-A- H03 245 404        JP-A- H06 184 409
JP-A- 2004 047 174        JP-A- 2004 055 543
JP-A- 2004 335 651        JP-A- 2005 294 254
JP-A- 2008 042 152        JP-A- 2014 181 316
JP-A- 2015 162 392

(52) Cooperative Patent Classification (CPC): (Cont.)

C-Sets
**C08F 265/06, C08F 220/28;**
**C08F 265/06, C08F 220/325;**
**C09D 4/06, C08F 265/06**

**Description**

TECHNICAL FIELD

The present invention according to the appended claims relates to a conductive resin composition and a method for manufacturing a shielded package using the same.

BACKGROUND ART

In recent years, electronic devices such as mobile phones and tablet terminals are equipped with radio communication functions using 10 MHz to 1000 MHz electromagnetic waves, such as RFID (Radio Frequency IDentification) and non-contact charging functions, along with many electronic components. Such electronic components are highly sensitive to electromagnetic waves. Therefore, such electronic components have a problem that they easily malfunction when exposed to external electromagnetic waves.

On the other hand, in order to achieve both reduction in size and weight and an increase in functionality of electronic devices, it is required to increase mounting density of electronic components. However, when the mounting density is increased, there is a problem that the number of electronic components affected by electromagnetic waves increases.

Typically, a so-called shielded package is known as means for solving this problem. According to this means, the electronic component is covered with a shield layer together with the package. This prevents electromagnetic waves from entering the electronic component. For example, PATENT LITERATURE 1 has the following description. According to the description, a surface of the package is coated with the conductive resin composition containing conductive particles by spraying. The conductive resin is then cured by heating. Thus, an electromagnetic shielding member having a high shielding effect can be easily obtained.

Further, as conductive pastes applicable to electromagnetic shielding, for example, PATENT LITERATURES 2 to 7 describe conductive pastes in which micron-sized conductive fillers and nano-sized conductive fillers are used in combination. According to the description in the PATENT LITERATURES, a gap existing between the micron-sized conductive fillers can be filled by using the nano-sized conductive fillers in combination. As a result, good shielding properties can be obtained.

CITATION LIST

PATENT LITERATURE

PATENT LITERATURE 1: JP-A-2003-258137
PATENT LITERATURE 2: JP-A-2014-181316
PATENT LITERATURE 3: JP-A-2005-294254
PATENT LITERATURE 4: JP-A-2010-113912
PATENT LITERATURE 5: JP-A-2010-118280
PATENT LITERATURE 6: WO 2017/023747 A
PATENT LITERATURE 7: JP-A-2015-162392

SUMMARY OF THE INVENTION

PROBLEMS TO BE SOLVED BY THE INVENTION

However, there is no conductive paste that focuses on preventing penetration of electromagnetic waves of 10 MHz to 1000 MHz. There has been room for improvement in the shielding properties against electromagnetic waves of 10 MHz to 1000 MHz of the shield layer made of the typical conductive paste.

Further, when using the nanosized conductive filler, (meth)acrylic resin is used in many cases from a viewpoint of improving dispersibility of the nanosized conductive filler. However, when the conductive resin composition using the (meth)acrylic resin is applied to the shield layer, if the shield layer is exposed to a high temperature such as a solder reflow process, there arises a problem that adhesion between the shield layer and the package tends to decrease.

Furthermore, as a means for improving the shielding properties against electromagnetic waves of 10 MHz to 1000 MHz, it is conceivable to blend a large amount of conductive filler. However, in that case, there has been a possibility that a problem of adhesion between the shield layer and the package appears more remarkably.

The present invention has been made in view of the above. That is, an object of the present invention is to provide the conductive resin composition in which the shield layer having good shielding properties even against electromagnetic waves of 10 MHz to 1000 MHz can be formed by spray coating. The shield layer obtained here has good adhesion to the package. Another object of the present invention is to provide a method for manufacturing the shielded package in which the shield layer as described above can be easily formed.

SOLUTION TO THE PROBLEMS

A conductive resin composition of the present invention is defined in present claims 1 to 3.

The conductive resin composition , as defined in present claim 4, is used for shielding a package of an electronic component.

A method for manufacturing a shielded package according to present claim 5 of the present invention, covering with a shield layer a package including an electronic component mounted on a substrate and sealed with a sealing material, includes at least: a step of sealing the electronic component by mounting a plurality of electronic components on the substrate and curing the sealing material filling over the substrate; a step of cutting the sealing material between the plurality of electronic components to form grooves, and individualizing the package of the electronic components on the substrate by the grooves; a step of coating a surface of the individualized package by spraying with the conductive resin composition according to any one of claims 1 to 4; a step of forming the shield layer by heating the substrate having the surface of the package coated with the conductive resin composition and by curing the conductive resin composition; and a step of obtaining the shielded package separated into individual pieces by cutting the substrate along the grooves.

EFFECTS OF THE INVENTION

According to the conductive resin composition of the present invention, a coating film having a uniform thickness can be formed by a spray method. Further, the obtained coating film can protect the package from electromagnetic waves of 10 MHz to 1000 MHz. Therefore, by spray-coating the package surface with the conductive resin composition of the present invention, it is possible to easily form the shield layer having excellent shielding effect and excellent adhesion to the package.

Further, according to the method for manufacturing the shielded package of the present invention, it is possible to efficiently manufacture the shielded package having excellent shielding properties and adhesion to the package as described above without using a large-scale apparatus.

BRIEF DESCRIPTION OF THE DRAWINGS

Figs. 1(a) to 1(e) are schematic cross-sectional views showing an embodiment of a method for manufacturing a shielded package.
Fig. 2 is a plan view showing an example of the shielded package before individualization.
Fig. 3 is a plan view showing a substrate on which a sample of a cured product is formed, which is used for evaluating conductivity of a conductive coating film.

LIST OF REFERENCE NUMERALS

A: package individualized on substrate, B: shielded package separated into individual pieces, $B_1$, $B_2$, $B_9$: shielded package before separation into individual pieces, 1: substrate, 2: electronic component, 3: ground circuit pattern (cupper foil), 4: sealing material, 5: shield layer (conductive coating film), 11 to 19: groove, 20: substrate, 21: electrode pad, 22: cured product of conductive resin composition.

DESCRIPTION OF THE EMBODIMENTS

As described above, a conductive resin composition according to the present invention comprises at least: (A) a (meth)acrylic resin having a weight average molecular weight of 1.000 or more and 400,000 or less, wherein the weight average molecular weight is a value calculated using tetrahydrofuran as a mobile phase and a calibration curve in terms of polystyrene, measured by gel permeation chromatography, GPC; (B) a monomer having a glycidyl group and/or a (meth)acryloyl group in its molecule; (C) a conductive filler having an average particle diameter of 10 to 500 nm. wherein the average particle diameter refers to a particle diameter of a number-based average particle diameter D50, median diameter, measured by a laser diffraction/ scattering method; (D) a conductive filler having the average particle diameter of 1 to 50 pm; and (E) a radical polymerization initiator, wherein a sum of the content of the conductive filler (C) and the content of the conductive filler (D) is 2.000 to 80,000 parts by mass based on 100 parts by mass of the total amount of the (meth)acrylic resin (A) and the monomer (B), a content ratio of the conductive filler (C) and the conductive filler (D) (the conductive filler (C): the conductive filler (D)) is 5:1 to 1:10 by mass ratio, the monomer (B) is selected from the group consisting of glycidyl compounds such as ethyl glycidyl ether, butyl glycidyl ether, t-butyl glycidyl ether, allylglycidyl ether, benzyl glycidyl ether, glycidyl phenyl ether, bisphenol A diglycidyl ether, compounds having an acryloyl group or a methacryloyl group such as isoamyl acrylate, neopentyl glycol diacrylate, trimethylolpropane triacrylate, ditrimethylolpropane tetraacrylate, 2-hydroxy-3- acryloyloxypropyl methacrylate, ethylene glycol dimethacrylate, diethylene glycol dimethacrylate, and compounds having the glycidyl group and the (meth)acryloyl group such as acrylic acid glycidyl ether, methacrylic acid glycidyl ether, and 4-hydroxybutyl acrylate glycidyl ether, and combinations thereof,and the content of the monomer (B) is preferably 40 to 99 parts by mass in the total amount of 100 parts by mass with the (meth)acrylic resin (A).

Use of the conductive resin composition is not particularly limited. It is preferably used to obtain a shielded package by forming a shield layer on a surface of the package before or after separation into individual pieces. Here, the shield layer can be formed by spraying the surface of the package with the conductive resin composition in the form of mist using a spray or the like.

The (meth)acrylic resin (A) is not particularly limited as long as it is a polymer containing at least acrylic acid ester and/or methacrylic acid ester as constituent monomers. Examples of polymers that can be used include a polymer containing as the constituent monomers at least one selected from the group consisting of methyl acrylate, ethyl acrylate, propyl acrylate, n-butyl acrylate, methyl methacrylate, ethyl methacrylate, propyl methacrylate, and n-butyl methacrylate. The constituent monomers other than acrylic acid ester or methacrylic acid ester may be contained therein within the scope not departing from the object of the present invention. When two or more of monomers are contained therein, the polymer may be any one of an alternating copolymer, a random copolymer, a block copolymer, and a graft copolymer. Here, "(meth)acrylic resin" is a general term for "acrylic resin" and "methacrylic resin".

The (meth)acrylic resin (A) has a weight average molecular weight of 1,000 or more, preferably 5,000 or more, more preferably 7,000 or more, and still more preferably 10,000 or more. Further, the weight average molecular weight is 400,000 or less, preferably 200,000 or less, more preferably 150,000 or less, and still more preferably 50,000 or less. Note that the "weight average molecular weight" in the present specification can be measured by gel permeation chromatography (GPC). That is, the weight average molecular weight is a value calculated using tetrahydrofuran as a mobile phase and a calibration curve in terms of polystyrene.

As such a (meth)acrylic resin, for example, a copolymer for baking paste according to JP-A-2016-155920, JP-A-2015-059196, JP-A-2016-196606, or WO2016/132814 can be used. Commercially available (meth)acrylic resins can also be used. For example, "KC-1100" or "KC-1700P" produced by Kyoeisha Chemical Co., Ltd. can be used.

The monomer (B) is a compound having the glycidyl group and/or the (meth)acryloyl group in the molecule. The monomer (B) is preferably a compound having the glycidyl group and the (meth)acryloyl group in the molecule. Note that, in the present specification, the "monomer (B)" includes oligomers and prepolymers having a molecular weight of less than 1,000.

The monomer (B) is selected from the group consisting of glycidyl compounds such as ethyl glycidyl 1 ether, butyl glycidyl ether, t-butyl glycidyl ether, allyl glycidyl ether, benzyl glycidyl ether, glycidyl phenyl ether, bisphenol A diglycidyl 1 ether, compounds having an acryloyl group or a methacryloyl group such as isoamyl acrylate, neopentyl glycol diacrylate, trimethylolpropane triacrylate, ditrimethylolpropane tetraacrylate, 2-hydroxy-3- acryloyloxypropyl methacrylate, ethylene glycol dimethacrylate, diethylene glycol dimethacrylate and compounds having the glycidyl group and the (meth)acryloyl group such as acrylic acid glycidyl ether, methacrylic acid glycidyl ether, and 4-hydroxybutyl acrylate glycidyl ether, and combinations thereof.

The one of monomer (B) can be used alone. Two or more of monomers (B) can be used in combination. As described above, when the (meth)acrylic resin is used for the conductive resin composition, adhesion between the heat-cured shield layer and the package tends to be reduced. However, by using the monomers (B) in combination, even when the conductive filler (C) and the conductive filler (D) are blended in a large amount, excellent adhesion between the shield layer and the package can be easily obtained.

The content of the monomer (B) is 40 to 99 parts by mass, and preferably 50 to 99 parts by mass in the total amount of 100 parts by mass with the (meth)acrylic resin (A). Hereinafter, in the present specification, a component containing both the (meth)acrylic resin (A) and the monomer (B) is referred to as a binder component.

The conductive filler (C) having an average particle diameter of 10 to 500 nm is not particularly limited. Preferred conductive filler (C) is copper nanoparticle, silver nanoparticle, or gold nanoparticle. The conductive filler (C) having an average particle diameter of 10 to 500 nm can fill a gap between micron-sized conductive fillers. Therefore, the conductive filler can be easily blended with a high content. As a result, shielding properties against electromagnetic waves of 10 MHz to 1000 MHz can be improved. Here, in the present specification, the "average particle diameter" refers to a particle diameter of a number-based average particle diameter D50 (median diameter) measured by a laser diffraction/scattering method.

The content of the conductive filler (C) is not particularly limited. The conductive filler (C) is preferably 50 to 75,000 parts by mass, more preferably 100 to 35,000 parts by mass, still more preferably 300 to 10,000 parts by mass, and particularly preferably 500 to 5,000 parts by mass based on 100 parts by mass of the binder component.

The conductive filler (D) having an average particle diameter of 1 to 50 $\mu$m is not particularly limited. Preferred conductive filler (D) is copper powder, silver powder, gold powder, silver-coated copper powder, or silver-coated copper alloy powder. From the viewpoint of cost reduction, a more preferred conductive filler (D) is copper powder, silver-coated copper powder, or silver-coated copper alloy powder. When the average particle diameter of the conductive filler (D) is 1 $\mu$m or more, the conductive filler (D) can prevent aggregation of the filler due to its good dispersibility and is hardly oxidized. When the average particle size is 50 $\mu$m or less, connectivity with a ground circuit of the package is good.

The silver-coated copper powder has a copper powder and a silver layer or a silver-containing layer that covers at least a part of the copper powder particles. The silver-coated copper alloy powder has a copper alloy powder and a silver layer or a silver-containing layer that covers at least a part of the copper alloy particles. The copper alloy particles are made of, for example, nickel having a content of 0.5 to 20 mass%, zinc having a content of 1 to 20 mass%, and balance copper. The balance copper may contain inevitable impurities. Thus, by using copper alloy particles having a silver coating layer, the shielded package excellent in shielding properties and discoloration resistance can be easily obtained.

Examples of shape of the conductive filler (D) include flake shape (scale shape), dendritic shape, spherical shape, fiber shape, and irregular shape (polyhedron). A preferred shape is the flake shape from the viewpoint of obtaining the shield layer having a lower resistance value and improved shielding properties.

Further, when the conductive filler (D) is flaky, a tap density of the conductive filler (D) is preferably 4.0 to 6.5 g/cm$^3$. When the tap density is within the above range, conductivity of the shield layer is better.

Further, when the conductive filler (D) is flaky, an aspect ratio of the conductive filler (D) is preferably 2 to 10. When the aspect ratio is within the above range, the conductivity of the shield layer is better.

The content of the conductive filler (D) is not particularly limited. The content is preferably 400 to 75,000 parts by mass, more preferably 400 to 55,000 parts by mass, still more preferably 400 to 45,000 parts by mass, and particularly preferably 400 to 30,000 parts by mass based on 100 parts by mass of the binder component. When the content is 400 parts by mass or more, the conductivity of the shield layer is good. Therefore, excellent shielding properties against electromagnetic waves in a low frequency range of 10 MHz band can be easily obtained. When the content is 75,000 parts by mass or less, the adhesion between the shield layer and the package and physical properties of the cured conductive resin composition are likely to be good. Therefore, the shield layer is less likely to be chipped when cut with a dicing saw described below.

The total content of the conductive filler (C) and the conductive filler (D) is 2,000 to 80,000 parts by mass, preferably 2,000 to 65,000 parts by mass, more preferably 2,000 to 50,000 parts by mass, and still more preferably 2,000 to 35,000 parts by mass based on 100 parts by mass of the binder component. When the content is 2,000 parts by mass or more, the excellent shielding properties against electromagnetic waves in the low frequency range of 10 MHz band can be easily obtained. When the content is 80,000 parts by mass or less, the excellent adhesion between the shield layer and the package can be easily obtained.

The content ratio of the conductive filler (C) and the conductive filler (D) (conductive filler (C):conductive filler (D)) is 5: 1 to 1:10 by mass ratio.

The radical polymerization initiator (E) is not particularly limited. For example, a thermal polymerization initiator that starts radical polymerization by heating, or an energy beam polymerization initiator that starts radical polymerization by energy beam irradiation can be used.

The thermal polymerization initiator is not particularly limited. Typically used organic peroxide compounds or azo compounds can be used as appropriate.

Examples of organic peroxide polymerization initiators include methyl ethyl ketone peroxide, cyclohexanone peroxide, methyl cyclohexanone peroxide, methyl acetoacetate peroxide, acetyl acetate peroxide, 1,1-bis(t-hexylperoxy)-3,3,5-trimethylcyclohexane, 1,1-bis(t-hexylperoxy)-cyclohexane, 1,1-bis(t-butylperoxy)-3,3,5-trimethylcyclohexane, 1,1-bis(t-butylperoxy)-2-methylcyclohexane, 1,1-bis(t-butylperoxy)-cyclohexane, 1,1-bis(t-butylperoxy)cyclododecane, t-hexylperoxybenzoate, 2,5-dimethyl-2,5-bis(benzoylperoxy)hexane, t-butylperoxyallyl monocarbonate, t-butyl trimethylsilyl peroxide, 3,3',4,4'-tetra(t-butylperoxycarbonyl)benzophenone, and 2,3-dimethyl-2,3-diphenylbutane.

Further, examples of azo polymerization initiators include 2-phenylazo-4-methoxy-2,4-dimethylvaleronitrile, 1-[(1-cyano-1-methylethyl)azo]formamide, 1,1'-azobis(cyclohexane-1-carbonitrile), 2,2'-azobis(2-methylbutyronitrile), 2,2'-azobisisobutyronitrile, 2,2'-azobis(2,4-dimethylvaleronitrile), 2,2'-azobis(2-methylpropionamidine) dihydrochloride, 2,2'-azobis(2-methyl-N-phenylpropionamidine) dihydrochloride, 2,2'-azobis[N-(4-chlorophenyl)-2-methylpropionamidine] dihydride chloride, 2,2'-azobis[N-(4- hydroxyphenyl)-2-methylpropionamidine] dihydrochloride, 2,2'-azobis[2-methyl-N-(phenylmethyl)propionamidine] dihydrochloride, and 2,2'-azobis(isobutyric acid) dimethyl.

One kind of the thermal polymerization initiator can be used alone. Two or more of the above thermal polymerization initiators can also be used in combination.

In the conductive resin composition of the present invention, the content of the radical polymerization initiator (E) only needs to be an amount stoichiometrically required for the binder component. Although the content of the radical polymerization initiator (E) varies depending on its type, it is preferably 0.1 to 30 parts by mass, and more preferably 1 to 15 parts by mass as a guideline based on 100 parts by mass of the binder component in the case of the thermal polymerization initiator. Further, in the case of the energy beam polymerization initiator, the content is preferably 0.05 to 15 parts by mass, and more preferably 0.1 to 10 parts by mass. When the content of the radical polymerization initiator is within this range, the conductive resin composition is sufficiently cured. Further, the adhesion between the shield layer and the package surface, and the conductivity of the shield layer are good. Therefore, the shield layer having an excellent shielding effect can be easily obtained. Further, by selecting the type and amount of the radical polymerization initiator, the polymerization initiator can be used depending on purpose such as shortening of curing time or long-term storage stability at room temperature.

Further, to the conductive resin composition of the present invention, a known additive such as an antifoaming agent, a thickener, a pressure-sensitive adhesive, a filler, a flame retardant, or a colorant can be added within a range not impairing the object of the invention.

The conductive resin composition of the present invention preferably has a lower viscosity than a so-called conductive paste so that the package surface can be uniformly coated with the conductive resin composition by spraying.

The viscosity of the conductive resin composition of the present invention is preferably adjusted as appropriate depending on application and an equipment used for coating. The viscosity is not particularly limited. General guidelines are as described below. A method for measuring the viscosity is not limited either. If the conductive resin composition has a low viscosity, the viscosity can be measured with a cone-plate type rotational viscometer (so-called cone-plate viscometer). If the conductive resin composition has a high viscosity, the viscosity can be measured with a single cylindrical rotational viscometer (so-called B-type or BH-type viscometer).

When measuring with the cone-plate type rotational viscometer, the viscosity measured at 0.5 rpm using a corn spindle CP40 (cone angle: 0.8°, cone radius: 24 mm) manufactured by Brookfield Engineering Laboratories, Inc. is preferably 100 mPa s or more, and more preferably 150 mPa·s or more. When the viscosity is 100 mPa·s or more, it is possible to prevent dripping when a coated surface is not horizontal, and to easily form a conductive coating film without unevenness.

Note that when the viscosity is around 100 mPa·s or lower, a thin film is formed with a smaller coating amount per time in order to obtain a uniform coating film having a desired thickness. Then, operation of forming a thin film on the thin film is repeated. Such a so-called overcoating method is effective. Note that high viscosity is not a problem as long as the viscosity can be measured with the cone-plate type rotational viscometer.

When measuring with the single cylindrical rotational viscometer, the viscosity measured at 10 rpm using a rotor No. 5 is preferably 30 dPa·s or less, and more preferably 25 dPa s or less. When the viscosity is 30 dPa·s or less, it is possible to prevent a spray nozzle from being clogged, and to easily form the conductive coating film without unevenness. Note that low viscosity is not a problem as long as the viscosity can be measured with the single cylindrical rotational viscometer.

The viscosity of the conductive resin composition varies depending on the viscosity of the binder component, the content of the conductive filler, and the like. Therefore, a solvent can be used to set the viscosity within the above range. The solvent that can be used in the present invention is not particularly limited. Examples include propylene glycol monomethyl ether, 3-methoxy-3-methyl-1-butanol, 3-methoxy-3-methyl-1-butyl acetate, acetone, methyl ethyl ketone, acetophenone, methyl cellosolve, methyl cellosolve acetate, Methyl Carbitol, diethylene glycol dimethyl ether, tetrahydrofuran, methyl acetate, and butyl acetate. One of the solvents can be used alone. Two or more solvents may also be used in combination.

The content of the solvent is preferably adjusted as appropriate depending on the use of the conductive resin composition, the equipment used for coating, or the like. Therefore, the content of the solvent varies depending on the viscosity of the binder component, the content of the conductive filler, and the like. The content as a guideline is about 10 to 60 mass% with respect to the total amount of the components (excluding the solvent) of the conductive resin composition.

The shield layer obtained by the conductive resin composition of the present invention is excellent in adhesion to the ground circuit formed of copper foil or the like. Specifically, the adhesion between the copper foil of the ground circuit exposed from a part of the shielded package and the shield layer is good. Therefore, after coating the conductive resin composition on the surface of the shielded package to form the shield layer, when the package is cut into individual pieces, it is possible to prevent the shield layer from being peeled off from the ground circuit due to impact at the time of cutting.

When the coating film formed from the conductive resin composition of the present invention is used as the shield layer, its specific resistance is preferably $5.0 \times 10^{-5}$ $\Omega$·cm or less from the viewpoint of obtaining excellent shielding properties against electromagnetic waves in the low frequency range of 10 MHz band.

An embodiment of a method for obtaining the shielded package using the conductive resin composition of the present invention will be described with reference to the drawings.

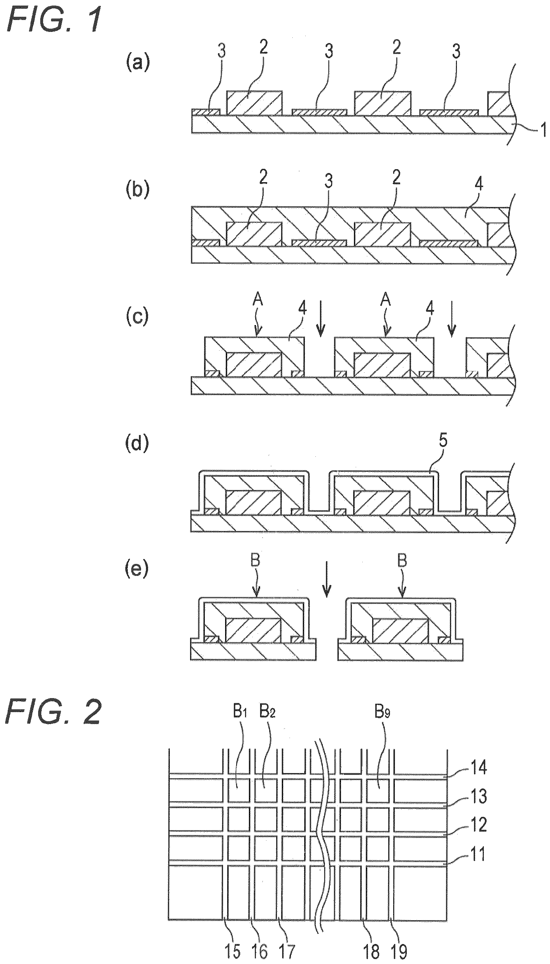

First, as shown in Fig. 1(a), a plurality of electronic components (IC and the like) 2 are mounted on a substrate 1. In this way, a device provided with a ground circuit pattern (copper foil) 3 between the plurality of electronic components 2 is prepared.

As shown in Fig. 1(b), a sealing material 4 filling over the electronic component 2 and the ground circuit pattern 3 is cured to seal the electronic component 2.

As shown by an arrow in Fig. 1(c), the sealing material 4 is cut between the plurality of electronic components 2 to form a groove. The package of electronic components of the substrate 1 is individualized by the grooves. A reference numeral A denotes the individualized package. At least a part of the ground circuit is exposed from a wall surface forming the groove. Further, a bottom of the groove does not completely penetrate the substrate.

On the other hand, the binder component, the conductive filler, and a predetermined amount of curing agent described above and the solvent used as necessary are mixed. Thus, the conductive resin composition is prepared.

The package surface is sprayed with the conductive resin composition in the form of mist by a known spray gun or the like. In this way, the package surface is evenly coated. A spray pressure, a spray flow rate, and a distance between a spray port of the spray gun and the package surface at this time are appropriately set as necessary.

The package coated with the conductive resin composition is heated to sufficiently dry the solvent. Thereafter, the conductive resin composition is sufficiently cured by further heating. As shown in Fig. 1(d), a shield layer (conductive coating film) 5 is formed on the package surface. Heating conditions at this time can be set as appropriate. Fig. 2 is a plan view showing the substrate in this state. Reference numerals $B_1$, $B_2$, ... $B_9$ respectively denote the shielded packages before separation into individual pieces. Reference numerals 11 to 19 respectively denote the grooves between the shielded packages.

As shown by an arrow in Fig. 1(e), individualized packages B are obtained by cutting the substrate along the bottom of the groove of the package before separation into individual pieces with a dicing saw or the like.

The individualized package B obtained in this manner has a uniform shield layer formed on the package surface (all of an upper surface portion, side surface portions, and corner portions of boundaries between the upper surface portion and the side surface portions). Therefore, good shielding properties can be obtained. Further, the adhesion between the shield layer and the package surface and the ground circuit is excellent. Therefore, it is possible to prevent the shield layer from being peeled off from the package surface or the ground circuit due to impact when the package is separated into individual pieces with the dicing saw or the like.

Hereinafter, the content of the present invention will be described in detail based on Examples. However, the present invention is not limited to the following Examples. Further, in the following description, "part" or "%" is based on mass unless otherwise specified.

[Examples and Comparative Examples]

The conductive filler (c), the conductive filler (d), the conductive filler ($\alpha$), the conductive filler ($\beta$), the radical polymerization initiator, and the solvent were blended and mixed in proportions shown in Table 1 and 2 based on 100 parts by mass of the total amount of the following (meth)acrylic resins (a1 to a3) and monomers (b1 to b3). Thus, the conductive resin compositions were obtained. Details of the components used are as follows.

(Meth)acrylic resin (a1): molecular weight = 17,000
(Meth)acrylic resin (a2): molecular weight = 100,000, "KC-1700P" produced by Kyoeisha Chemical Co., Ltd.
(Meth)acrylic resin (a3): molecular weight = 130,000, "KC-1100" produced by Kyoeisha Chemical Co., Ltd.
Monomer (b1): 4-hydroxybutyl acrylate glycidyl ether
Monomer (b2): "Light Acrylate P-1A (N)" produced by Kyoeisha Chemical Co., Ltd.
Monomer (b3): "ED503" produced by ADEKA Corporation
Conductive filler (c): Silver particles (average particle size = 150 nm, spherical)
Conductive filler (d): Silver-coated copper alloy powder (average particle size = 5 $\mu$m, flaky, aspect ratio = 2 to 10, tap density = 5.8 g/cm$^3$)
Conductive filler ($\alpha$): Silver particles (average particle size = 8 nm, spherical, blended as an aqueous solution in which silver particles are dispersed with a surfactant)
Conductive filler ($\beta$): Silver particles (average particle size = 800 nm, spherical)
Radical polymerization initiator (e): 2,2'-azobis (isobutyric acid) dimethyl
Solvent: Methyl ethyl ketone (MEK)

The conductive resin compositions of the above Examples and Comparative Examples were evaluated as follows. Results are shown in Tables 1 and 2.

(1) Conductivity of conductive coating film

The conductivity of the conductive coating film obtained from the conductive resin composition of Example 1 was evaluated by specific resistance.

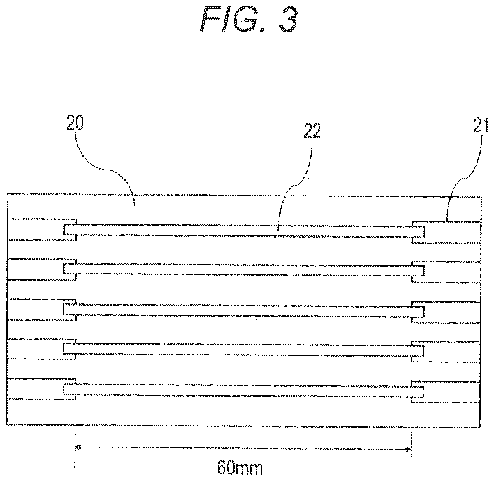

Specifically, as shown in Fig. 3, a glass epoxy substrate 20 was masked by a polyimide film having a thickness of 55 $\mu$m and having a slit having a width of 5 mm. Electrode pads 21 formed of copper foil were provided at both ends of the glass epoxy substrate 20 with an interval of 60 mm. The polyimide film was bonded to the glass epoxy substrate 20 so that an end portion of the slit overlaps the electrode pads 21 on the both ends of the glass epoxy substrate 20. The substrate and the polyimide film were spray-coated thereon with the conductive resin compositions obtained in the respective Examples and Comparative Examples using a spray device (SL-940E manufactured by Nordson ASYMTEK).

The conductive resin composition was cured by heating at 190°C for 30 minutes. Thereafter, the polyimide film was peeled off. The substrate 20 having a cured product 22 formed to connect the electrode pads 21 at both ends thereof was obtained. The cured product 22 had a length of 70 mm, a width of 5 mm, and a thickness of about 20 $\mu$m. The resistance value ($\Omega$) between the electrode pads of a sample of the cured product was measured using a tester. The specific resistance ($\Omega \cdot$cm) was calculated from a cross-sectional area (S, cm$^2$) and a length (L, cm) by the following equation (1).

[Equation 1]

$$\text{Specific resistance} = S/L \times R \qquad (1)$$

A total of 15 cured samples were formed, including five cured samples respectively for three glass epoxy substrates. The cross-sectional area, length, and specific resistance of the samples were determined as average values of the cured samples. Note that if the specific resistance is $5 \times 10^{-5}$ $\Omega \cdot$cm or less, it can be suitably used as the shield layer for blocking electromagnetic waves in the low frequency range of 10 MHz band.

Further, the specific resistances were also measured for other Examples and Comparative Examples.

(2) Adhesion of conductive resin composition (comparison before and after solder dip)

The adhesion between the shield layer and the package surface or the ground circuit was evaluated based on JIS K 5600-5-6: 1999 (Cross-cut test).

Specifically, a copper clad laminate was prepared for evaluation of adhesion to the ground circuit. A mold resin for evaluating adhesion to the package surface was also prepared. Each of the copper clad laminate and the mold resin was masked with a polyimide tape so that an opening having a width of 5 cm and a length of 10 cm was formed. After they were spray-coated with the conductive resin composition using a spray coating apparatus SL-940E (manufactured by Nordson ASYMTEK), the conductive resin composition was cured by heating at 190°C for 30 minutes. Thereafter, the polyimide tape was peeled off. In this way, the coating film having a thickness of about 15 $\mu$m was formed. The cross-cut test was performed on the copper foil and the mold resin having a formed coating film. The cross-cut test was performed before reflow treatment. In addition, the cross-cut test was also performed after performing three reflow treatments at a maximum temperature of 260°C for 10 seconds.

Adhesion was evaluated according to the following criteria.

0: An edge of the cut is completely smooth and there is no peeling in any lattice cell.

1: Small peeling of the coating film occurs at an intersection of the cuts. The probability that a crosscut portion is affected is clearly not above 5%.

2: The coating film is peeled along the edge of the cut and/or at the intersection. The probability that the crosscut portion is affected is clearly above 5% but not above 15%.

3: The coating film is partially or completely largely peeled along the edge of the cut, and/or various parts of the lattice cell are partially or completely peeled off. The probability that the crosscut portion is affected is clearly above 15% but not above 35%.

4: The coating film is partially or completely largely peeled along the edge of the cut, and/or several lattice cells are partially or completely peeled off. The probability that the crosscut portion is affected is clearly not above 35%.

5: Any of degree of peeling that cannot be classified even with classification 4.

Table 1]

| | Examples | | | | | | | | | | | | |
|---|---|---|---|---|---|---|---|---|---|---|---|---|---|
| | 1 | 2 | 3 | 4 | 5 | 6 | 7 | 8 | 9 | 10 | 11 | 12 | 13 |
| (Meth)acrylic resin (a1) | 37 | 1 | 66 | 37 | 37 | 37 | 37 | 37 | 50 | 37 | - | - | 27 |
| (Meth)acrylic resin (a2) | - | - | - | - | - | - | - | - | - | - | - | 37 | - |
| (Meth)acrylic resin (a3) | - | - | - | - | - | - | - | - | - | - | 37 | - | - |
| Monomer (b1) | 63 | 99 | 34 | 63 | 63 | 63 | - | - | 50 | 63 | 63 | 63 | 73 |
| Monomer (b2) | - | - | - | - | - | - | 63 | - | - | - | - | - | - |
| Monomer (b3) | - | - | - | - | - | - | - | 63 | - | - | - | - | - |
| Conductive filler (C) | 3750 | 600 | 5000 | 3750 | 3750 | 3750 | 3750 | 3750 | 2500 | 2500 | 3750 | 3750 | 4860 |
| Conductive filler (D) | 22500 | 1430 | 30000 | 22500 | 22500 | 22500 | 22500 | 22500 | 500 | 25000 | 22500 | 22500 | 8748 |
| Radical polymerization initiator (e) | 5 | 5 | 5 | 0.5 | 35 | 6 | 5 | 5 | 5 | 5 | 5 | 5 | 5 |
| Solvent | 6563 | 508 | 8750 | 6563 | 6563 | 6563 | 6563 | 6563 | 775 | 6900 | 6563 | 6563 | 3430 |
| Curing conditions | 190°C×30 minutes | 190°C×30 minutes | 190°C×30 minutes | 200°C×30 minutes | 190°C×30 minutes | 190°C×30 minutes | 190°C×30 minutes | 190°C×30 minutes | 190°C×30 minutes | 190°C×30 minutes | 190°C×30 minutes | 190°C×30 minutes | 190°C×30 minutes |
| Conductivity of conductive coating film (Specific resistance, $10^{-5}\Omega\cdot cm$) | 0.73 | 3.2 | 0.67 | 0.96 | 1.2 | 1.5 | 2.0 | 2.10 | 3.10 | 3.0 | 1.50 | 1.30 | 0.70 |
| Cross-cut test — Before reflow | 0 | 0 | 1 | 0 | 0 | 0 | 0 | 0 | 0 | 0 | 0 | 0 | 0 |
| Cross-cut test — After reflow | 0 | 0 | 1 | 0 | 0 | 0 | 0 | 0 | 0 | 0 | 0 | 0 | 0 |

[Table 2]

| | | Comparative Examples | | | | | |
|---|---|---|---|---|---|---|---|
| | | 1 | 2 | 3 | 4 | 5 | 6 |
| (Meth)acrylic resin (a1) | | 1 | 100 | 77 | 1 | 37 | - |
| (Meth)acrylic resin (a2) | | - | - | - | - | - | - |
| (Meth)acrylic resin (a3) | | - | - | - | - | - | 37 |
| Monomer (b1) | | 99 | - | 23 | 99 | 63 | 63 |
| Monomer (b2) | | - | - | - | - | - | - |
| Monomer (b3) | | - | - | - | - | - | - |
| Conductive filler (C) | | 70 | 3750 | 5138 | 150 | - | - |
| Conductive filler (D) | | 350 | 22500 | 923 | 2000 | 22500 | 22500 |
| Conductive filler (a) | Silver particles | - | - | - | - | 3750 | - |
| | Solvent + Surfactant | - | - | - | - | 2500 | - |
| Radical polymerization initiator (e) | | 5 | 5 | 5 | 5 | 5 | 5 |
| Solvent | | 105 | 6563 | 1540 | 560 | 4000 | 8000 |
| Curing conditions | | 190°C×30 minutes | 190°C×30 minutes | 190°C×30 minutes | 200°C×30 minutes | 190°C×30 minutes | 190°C×30 minutes |
| Conductivity of conductive coating film (Specific resistance, $10^{-5}\Omega\cdot$cm) | | 9.0 | 0.67 | 1.1 | 5,5 | 6,1 | 2.30 |
| Cross-cut test | Before reflow | 0 | 4 | 4 | 0 | 3 | 1 |
| | After reflow | 0 | 4 | 4 | 0 | 3 | 2 |

EP 3 650 499 B1

From the results shown in Tables 1 and 2, all the coating films obtained from the conductive resin compositions of Examples have good conductivity. It was confirmed that the conductive resin compositions had excellent shielding properties even against electromagnetic waves in the low frequency range of 10 MHz band. It was also confirmed that the adhesion between the shield layer and the package surface or the ground circuit was good. Examples 3, 7 and 8 in Table 1 are not according to present claim 1.

**Claims**

1. A conductive resin composition comprising at least:

   (A) a (meth)acrylic resin having a weight average molecular weight of 1,000 or more and 400,000 or less, wherein the weight average molecular weight is a value calculated using tetrahydrofuran as a mobile phase and a calibration curve in terms of polystyrene, measured by gel permeation chromatography, GPC;
   (B) a monomer having a glycidyl group and/or a (meth)acryloyl group in its molecule;
   (C) a conductive filler having an average particle diameter of 10 to 500 nm, wherein the average particle diameter refers to a particle diameter of a number-based average particle diameter D50, median diameter, measured by a laser diffraction/scattering method;
   (D) a conductive filler having the average particle diameter of 1 to 50 $\mu$m; and
   (E) a radical polymerization initiator, wherein

   a sum of the content of the conductive filler (C) and the content of the conductive filler (D) is 2,000 to 80,000 parts by mass based on 100 parts by mass of the total amount of the (meth)acrylic resin (A) and the monomer (B),
   a content ratio of the conductive filler (C) and the conductive filler (D) (the conductive filler (C): the conductive filler (D)) is 5:1 to 1:10 by mass ratio,
   the monomer (B) is selected from the group consisting of glycidyl compounds such as ethyl glycidyl ether, butyl glycidyl ether, t-butyl glycidyl ether, allyl glycidyl ether, benzyl glycidyl ether, glycidyl phenyl ether, bisphenol A diglycidyl ether, compounds having an acryloyl group or a methacryloyl group such as isoamyl acrylate, neopentyl glycol diacrylate, trimethylolpropane triacrylate, ditrimethylolpropane tetraacrylate, 2-hydroxy-3-acryloyloxypropyl methacrylate, ethylene glycol dimethacrylate, diethylene glycol dimethacrylate, and compounds having the glycidyl group and the (meth)acryloyl group such as acrylic acid glycidyl ether, methacrylic acid glycidyl ether, and 4-hydroxybutyl acrylate glycidyl ether, and combinations thereof, and
   the content of the monomer (B) is 40 to 99 parts by mass in the total amount of 100 parts by mass with the (meth)acrylic resin (A).

2. The conductive resin composition according to claim 1, wherein the monomer (B) has a glycidyl group and a (meth)acryloyl group in the molecule.

3. The conductive resin composition according to claim 1 or 2, wherein the conductive filler (D) is at least one selected from the group consisting of copper powder, silver-coated copper powder, and silver-coated copper alloy powder.

4. A use of the conductive resin composition according to any one of claims 1 to 3 for shielding a package of an electronic component.

5. A method for manufacturing a shielded package which covers with a shield layer a package including an electronic component mounted on a substrate and sealed with a sealing material, the method comprising at least:

   a step of sealing the electronic component by mounting a plurality of electronic components on the substrate and curing the sealing material filling over the substrate;
   a step of cutting the sealing material between the plurality of electronic components to form grooves, and individualizing the package of the electronic components on the substrate by the grooves;
   a step of coating a surface of the individualized package by spraying with the conductive resin composition according to any one of claims 1 to 4;
   a step of forming the shield layer by heating the substrate having the surface of the package coated with the conductive resin composition and by curing the conductive resin composition; and
   a step of obtaining the shielded package separated into individual pieces by cutting the substrate along the grooves.

**Patentansprüche**

1.  Eine leitfähige Harzzusammensetzung, die zumindest folgende Merkmale aufweist:

    (A) ein (Meth-)Acrylharz mit einem Gewichtsmittel des Molekulargewichts von 1.000 oder mehr und 400.000 oder weniger, wobei das Gewichtsmittel des Molekulargewichts ein Wert ist, der berechnet wird unter Verwendung von Tetrahydrofuran als eine mobile Phase und einer Kalibrierkurve im Hinblick auf Polystyren, gemessen mittels Gelpermeationschromatographie, GPC;
    (B) ein Monomer mit einer Glycidyl-Gruppe und/oder einer (Meth-)Acryloyl-Gruppe in dem Molekül desselben;
    (C) einen leitfähigen Füllstoff mit einem durchschnittlichen Partikeldurchmesser von 10 bis 500 nm, wobei sich der durchschnittliche Partikeldurchmesser auf einen Partikeldurchmesser eines zahlenbasierten durchschnittlichen Partikeldurchmessers D50, mittleren Durchmesser, gemessen mittels einem Laserbeugungs-/-streuungsverfahren, bezieht;
    (D) einen leitfähigen Füllstoff mit einem durchschnittlichen Partikeldurchmesser von 1 bis 50 $\mu$m; und
    (E) einen initiator für radikalische Polymerisation, wobei

    eine Summe des Gehalts des leitfähigen Füllstoffs (C) und des Gehalts des leitfähigen Füllstoffs (D) 2.000 bis 80.000 Gewichtsteile basierend auf 100 Gewichtsteilen des Gesamtbetrags des (Meth-)Acrylharzes (A) und des Monomers (B) beträgt,
    ein Gehaltverhältnis des leitfähigen Füllstoffs (C) und des leitfähigen Füllstoffs (D) (der leitfähige Füllstoff (C):der leitfähige Füllstoff (D)) ein Massenverhältnis von 5:1 bis 1:10 aufweist,
    das Monomer (B) aus der Gruppe bestehend aus Glycidyl-Verbindungen wie beispielsweise Verbindungen mit Ethylgycidylether, Butylglycidylether, t-Butylglycidylether, Allylglycidylether, Benzylgylcidylether, Glycidylphenylether, Bisphenol-A-Diglycidylether ausgewählt ist, die eine Acryloyl-Gruppe oder eine Methacryloyl-Gruppe aufweisen, wie beispielsweise Isoamylacrylat, Neopentylglycol-Diacrylat, Trimethylolpropan-Triacrylat, Ditrimethylolpropan-Tetraacrylat, 2-Hydroxy-3-Acryloyloxypropyl-Methacrylat, Ethylenglycol-Diemethacrylat, Diethylenglycol-Dimethacrylat sowie Verbindungen mit der Glycidyl-Gruppe und der (Meth-)Acryloyl-Gruppe, wie beispielsweise Acrylsäure-Glycidylether, Methacrylsäure-Glycidylether und 4-Hydroxybutylacrylatglycidylether sowie Kombinationen davon, und
    der Gehalt des Monomers (B) 40 bis 99 Gewichtsteile in dem Gesamtbetrag von 100 Gewichtsteilen mit dem (Meth-)Acrylharz (A) beträgt.

2.  Die leitfähige Harzzusammensetzung gemäß Anspruch 1, bei der das Monomer (B) eine Glycidyl-Gruppe und eine (Meth-)Acryloyl-Gruppe in dem Molekül aufweist.

3.  Die leitfähige Harzzusammensetzung gemäß Anspruch 1 oder 2, bei der der leitfähige Füllstoff (D) zumindest einer ausgewählt aus der Gruppe bestehend aus Kupferpulver, versilbertem Kupferpulver und versilbertem Kupferlegierungspulver ist.

4.  Eine Verwendung der leitfähigen Harzzusammensetzung gemäß einem der Ansprüche 1 bis 3 zum Abschirmen eines Pakets einer elektronischen Komponente.

5.  Ein Verfahren zum Herstellen eines abgeschirmten Pakets, das mit einer Abschirmungsschicht ein Paket abdeckt, das eine elektronische Komponente umfasst, die auf einem Substrat angebracht ist und mit einem Dichtungsmaterial abgedichtet ist, wobei das Verfahren zumindest folgende Schritte aufweist:

    einen Schritt eines Abdichtens der elektronischen Komponente durch Anbringen einer Mehrzahl von elektronischen Komponenten auf dem Substrat und Aushärten der Dichtungsmaterialfüllung über dem Substrat;
    einen Schritt eines Schneidens des Dichtungsmaterials zwischen der Mehrzahl von elektronischen Komponenten, um Rillen zu bilden, und Individualisieren des Pakets der elektronischen Komponenten auf dem Substrat durch die Rillen;
    einen Schritt eines Beschichtens einer Oberfläche des individualisierten Pakets durch Besprühen mit der leitfähigen Harzzusammensetzung gemäß einem der Ansprüche 1 bis 4;
    einen Schritt eines Bildens der Abschirmungsschicht durch Erhitzen des Substrats, das die Oberfläche des Pakets aufweist, das mit der leitfähigen Harzzusammensetzung beschichtet ist, und durch Aushärten der leitfähigen Harzzusammensetzung; und

einen Schritt eines Erhaltens des abgeschirmten Pakets, das durch Schneiden des Substrats entlang den Rillen in individuelle Teile zerteilt ist.

## Revendications

1. Composition de résine conductrice comprenant au moins:

(A) une résine (méth)acrylique présentant un poids moléculaire moyen en poids de 1.000 ou plus et de 400.000 ou moins, où le poids moléculaire moyen en poids est une valeur calculée à l'aide de tétrahydrofurane comme phase mobile et une courbe d'étalonnage en termes de polystyrène, mesurée par chromatographie par perméation de gel, GPC;
(B) un monomère présentant un groupe glycidyle et/ou un groupe (méth)acryloyle dans sa molécule;
(C) une charge conductrice présentant un diamètre de particule moyen de 10 à 500 nm, où le diamètre de particule moyen se réfère à un diamètre de particule d'un diamètre de particule moyen à base de nombre D50, diamètre médian, mesuré par un procédé de diffraction/dispersion laser;
(D) une charge conductrice présentant un diamètre de particule moyen de 1 à 50 $\mu$m; et
(E) un initiateur de polymérisation radicalaire,
dans laquelle

une somme de la teneur en charge conductrice (C) et de la teneur en charge conductrice (D) est de 2.000 à 80.000 parties en masse sur base de 100 parties en masse de la quantité totale de résine (méth)acrylique (A) et du monomère (B),
un rapport de teneur en charge conductrice (C) et en charge conductrice (D) (la charge conductrice (C): la charge conductrice (D)) est de 5:1 à 1:10 en rapport de masse,
le monomère (B) est choisi dans le groupe constitué de composés glycidyliques tels que l'éther éthylglycidylique, l'éther butylglycidylique, l'éther t-butylglycidylique, l'éther allylglycidylique, l'éther benzylglycidylique, l'éther glycidylphénylique, l'éther diglycidylique de bisphénol A, les composés présentant un groupe acryloyle ou un groupe méthacryloyle tel que l'acrylate d'isoamyle, le diacrylate de néopentylglycol, le triacrylate de triméthylolpropane, le tétra-acrylate de ditriméthylolpropane, le méthacrylate de 2-hydroxy-3-acryloyloxypropyle, le diméthacrylate d'éthylèneglycol, le diméthacrylate de diéthylèneglycol, et les composés présentant le groupe glycidyle et le groupe (méth)acryloyle tel que l'éther glycidylique d'acide acrylique, l'éther glycidylique d'acide méthacrylique et l'éther glycidylique d'acrylate de 4-hydroxybutyle, et des combinaisons de ces derniers, et
la teneur du monomère (B) est de 40 à 99 parties en masse dans la quantité totale de 100 parties en masse avec la résine (méth)acrylique (A).

2. Composition de résine conductrice selon la revendication 1, dans laquelle le monomère (B) présente un groupe glycidyle et un groupe (méth)acryloyle dans la molécule.

3. Composition de résine conductrice selon la revendication 1 ou 2, dans laquelle la charge conductrice (D) est au moins l'une choisie dans le groupe constitué de poudre de cuivre, de poudre de cuivre recouverte d'argent et de poudre d'alliage de cuivre recouverte d'argent.

4. Utilisation de la composition de résine conductrice selon l'une quelconque des revendications 1 à 3 pour protéger un emballage d'un composant électronique.

5. Procédé de fabrication d'un emballage protégé qui recouvre d'une couche de protection un emballage comportant un composant électronique monté sur un substrat et scellé par un matériau d'étanchéité, le procédé comprenant au moins:

une étape consistant à sceller le composant électronique en montant une pluralité de composants électroniques sur le substrat et en laissant durcir la charge de matériau d'étanchéité sur le substrat;
une étape consistant à découper le matériau d'étanchéité entre la pluralité de composants électroniques pour former des rainures, et à individualiser l'emballage des composants électroniques sur le substrat par les rainures;
une étape consistant à revêtir une surface de l'emballage individualisé par pulvérisation avec la composition de résine conductrice selon l'une quelconque des revendications 1 à 4;

une étape consistant à former la couche de protection en chauffant le substrat présentant la surface de l'emballage revêtue de la composition de résine conductrice et en laissant durcir la composition de résine conductrice; et

une étape consistant à obtenir l'emballage protégé séparé en pièces individuelles en découpant le substrat le long des rainures.

FIG. 1

(a)

(b)

(c)

(d)

(e)

FIG. 2

# FIG. 3

60mm

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003258137 A
- JP 2014181316 A
- JP 2005294254 A
- JP 2010113912 A
- JP 2010118280 A
- WO 2017023747 A

- JP 2015162392 A
- JP 2016155920 A
- JP 2015059196 A
- JP 2016196606 A
- WO 2016132814 A